# EUROPEAN PATENT APPLICATION

(11) **EP 2 072 646 A1**
(43) Date of publication of application: **24.06.2009**
(21) Application number: 07829626.6
(22) Date of filing: 04.10.2007
(51) Int. Cl.: C30B 29/36, C30B 23/00

(54) **PROCESS FOR PRODUCING SINGLE CRYSTAL OF SILICON CARBIDE**

(30) Priority: 04.10.2006 JP 2006273347
(71) Applicant: SHOWA DENKO K.K., Tokyo 105-8518 (JP)
(72) Inventor: SHONAI, Tomohiro, Chichibu-shi Saitama 369-1871 (JP); KOGOI, Hisao, Chichibu-shi Saitama 369-1871 (JP); SAKAGUCHI, Yasuyuki, Chichibu-shi Saitama 369-1871 (JP)
(74) Representative: Strehl Schübel-Hopf & Partner
(86) International application number: PCT/JP2007/069888
(87) International publication number: WO 2008/044744

(57) **Abstract**

A method for producing an SiC single crystal comprises providing a low temperature region and a high temperature region in a crystal growth crucible (6); disposing a seed crystal substrate formed of an SiC single crystal in the low temperature region of the crystal growth crucible; disposing an SiC raw material in the high temperature region; and depositing a sublimation gas that sublimes from the SiC raw material on the seed crystal substrate to grow the SiC single crystal. A material used in the crucible member where the seed crystal is disposed is a material having a room-temperature linear expansion coefficient that differs from that of SiC by 1.0 × 10⁻⁶/K or less, and the crucible member where the seed crystal is disposed is made of SiC.

## Description

### Technical Field

The present invention relates to a method for producing a single crystal of silicon carbide (SiC), and in particular, relates to a method for producing an SiC single crystal **characterized in that** the growth of crystal is attained by a crystal growth method for growing a high-quality SiC single crystal.

### Background Art

SiC is a material which is physically and chemically stable, as demonstrated by having a high thermal conductivity, a superior thermal resistance and mechanical strength, and a high radiation resistance, and also having large band gap energy. Thus, SiC can be utilized, for example, as a material for an environmentally resistant device that can be used even under high temperature conditions, a radiation-resistant device, a power device for power control, and a short-wave light-emitting device, and the like. In addition, in recent years, SiC has in particular attracted attention as a power device for power control, and intense development thereof is progressing.

In order to promote widespread usage of SiC single crystals as a material for power devices for power control, crystals without defects, such as dislocations and the like, have been necessary.

A method of producing an SiC single crystal is known in which a crystal growth crucible is provided with a low temperature region and a high temperature region, a seed crystal substrate formed of an SiC single crystal is arranged in the low temperature region of the crystal growth crucible, the SiC raw material is arranged in the high temperature region, and a sublimation gas that is sublimed from the SiC raw material is deposited on the seed crystal substrate. In this case, there are problems in that defects occur in the seed crystal due to the stress when attaching the SiC seed crystal to the crucible and heat distortion during growth, and these defects cause the deterioration in the crystallinity of the growing crystal.

In order to solve these problems, a method has been proposed (refer, for example, to Japanese Patent Application Laid-Open No. 2004-269297) in which a stress absorbing material for relieving the thermal stress that acts between the SiC seed crystal and the platform which holds the SiC seed crystal is arranged therebetween, and the tensile strength of this stress absorbing material is 10 MPa or less. Another method has been proposed (Japanese Patent Application Laid-Open No. 2004-338971) in which, while growing the single crystal, an absorbing member is interposed between the SiC seed crystal and a lid member that supports this SiC seed crystal, the seed crystal is adhered to one surface of a plate portion in this absorbing member, a projection that has a pin pole is formed in the other surface thereof, and the absorbing member is coupled to the lid by this pin hole.

Even when using such growth methods, however, multiple defects still occur in the growing crystal. In particular, dislocations and micropipes that are produced at the interface between the seed crystal and the growing crystal reduce the quality of the SiC single crystal.

It is an object of the present invention to provide a method that solves the problems described above and that produces a high quality SiC single crystal having few crystal defects.

### Disclosure of the Invention

The present invention has been made to attain the objects described above and comprises the following aspects.
(1) The first aspect of the invention provides a method for producing an SiC single crystal comprising: providing a low temperature region and a high temperature region in a crystal growth crucible; disposing a seed crystal substrate formed of an SiC single crystal in the low temperature region of the crystal growth crucible; disposing an SiC raw material in the high temperature region, and depositing a sublimation gas that sublimes from the SiC raw material on the seed crystal substrate to grow the SiC single crystal, wherein a material used in the crucible member where the seed crystal is disposed is a material having a room-temperature linear expansion coefficient that differs from that of SiC by 1.0 × 10⁻⁶/K or less.
(2) The second aspect of the invention comprises the configuration of the first aspect, wherein the crucible member where the seed crystal is disposed is made of SiC.
(3) The third aspect of the invention comprises the configuration of the first aspect, wherein the crucible member where the seed crystal is disposed is made of an SiC single crystal.
(4) The fourth aspect of the invention comprises the configuration of the third aspect, wherein the crystal structure of the crucible member where the seed crystal is disposed and the crystal structure of the seed crystal are identical.
(5) The fifth aspect of the invention comprises the configuration of the third or fourth aspect, wherein the crystal face orientation of the crucible member where the seed crystal is disposed and the crystal face orientation of the seed crystal are matched so as to be within a range of -10° to +10°.
(6) The sixth aspect of the invention comprises the configuration of any one of the third to fifth aspects, wherein the crystal structure of the crucible member where the seed crystal is disposed is 4H.
(7) The seventh aspect of the invention comprises the configuration of the fifth or sixth aspect, wherein the crystal face orientation is an orientation having an offset within a range of +30° to -30° with respect to {0001}.
(8) The eighth aspect of the invention comprises the configuration of any one of the first to seventh aspects, wherein the thickness of the crucible member where the seed crystal is disposed is within a range of 0.7 mm to 50 mm.
(9) The ninth aspect of the invention comprises the configuration of any one the first to ninth aspects, wherein, when the seed crystal is disposed in the crucible member where the low temperature region is formed, a side portion of the seed crystal is held by using a member made of SiC.
(10) The tenth aspect of the invention comprises the configuration of any one of the first to ninth aspects, wherein the thickness of the wall portion inside the crystal growth crucible where the seed crystal is disposed is thinner than the wall thickness at other locations.
(11) The eleventh aspect of the invention comprises a method for producing an SiC single crystal including: providing a low temperature region and a high temperature region in a crystal growth crucible; disposing a seed crystal substrate formed of an SiC single crystal in the low temperature region of the crystal growth crucible; disposing an SiC raw material in the high temperature region; and depositing a sublimation gas that sublimes from the SiC raw material on the seed crystal substrate to grow an SiC single crystal, wherein a material having a room-temperature linear expansion coefficient that differs from that of SiC by 1.0 × 10⁻⁶/K or less is used as an SiC seed crystal supporting member between the crucible member where the low temperature region is formed and the seed crystal substrate.
(12) The twelfth aspect of the invention comprises the configuration of the eleventh aspect, wherein the SiC seed crystal supporting member is made of SiC.
(13) The thirteenth aspect of the invention comprises the configuration of the eleventh aspect, wherein the SiC single crystal supporting member is made of an SiC single crystal.
(14) The fourteenth aspect of the invention comprises the configuration of any one of the eleventh to thirteenth aspects, wherein the crystal structure of the SiC seed crystal supporting member is identical to the crystal structure of the seed crystal.
(15) The fifteenth aspect of the invention comprises the configuration of any one of the eleventh to fourteenth aspects, wherein the crystal face orientation of the SiC seed crystal supporting member and the crystal face orientation of the seed crystal are matched so as to be within a range of -10° to +10°.
(16) The sixteenth aspect of the invention comprises the configuration of any one of the thirteenth to fifteenth aspects, wherein the crystal structure of the SiC seed crystal supporting member is 4H.
(17) The seventeenth aspect of the invention comprises the configuration of the fifteenth or sixteenth aspect, wherein the crystal face orientation is an orientation having an offset within a range of +30° to -30° with respect to {0001}.
(18) The eighteenth aspect of the invention comprises the configuration of any one of the eleventh to seventeenth aspects, wherein the thickness of the SiC seed crystal supporting member is within a range of 0.7 mm to 50 mm.
(19) The nineteenth aspect of the invention comprises the configuration of any one of the eleventh to eighteenth aspects, wherein, when a seed crystal is disposed on the SiC seed crystal supporting member, a side portion of the seed crystal is held by using a member made of SiC.
(20) The twentieth aspect of the invention comprises the configuration of any one of the eleventh to nineteenth aspects, wherein the thickness of the wall portion that holds the supporting member in the crystal growth crucible is thinner than the wall thickness at other locations.
(21) The twenty-first aspect of the invention provides a semiconductor device composed of the single crystal produced by using the method for producing an SiC single crystal of any one of the first to twentieth aspects.
(22) The twenty-second aspect of the invention provides an inverter that is formed from the semiconductor device of the twenty-first aspect.

By using the method for producing an SiC single crystal of the present invention, it is possible to produce an SiC single crystal wafer having few crystal defects, and thus, it is possible to produce high-performance semiconductors, and in particular, inverters, with a high yield.

### Brief Description of the Drawings

FIG. 1 illustrates an example of a typical apparatus for producing an SiC single crystal.
FIG. 2 illustrates an example of an SiC seed crystal supporting portion that is used in the production method of the present invention.

### Best Mode for Carrying Out the Invention

The present invention will now be explained in detail.

The method for producing an SiC single crystal of the present invention is a method in which, fundamentally, a sublimation gas sublimed from SiC raw material at a temperature of 2000°C or more is introduced to a seed crystal formed of an SiC single crystal, and the SiC single crystal is grown on the seed crystal.

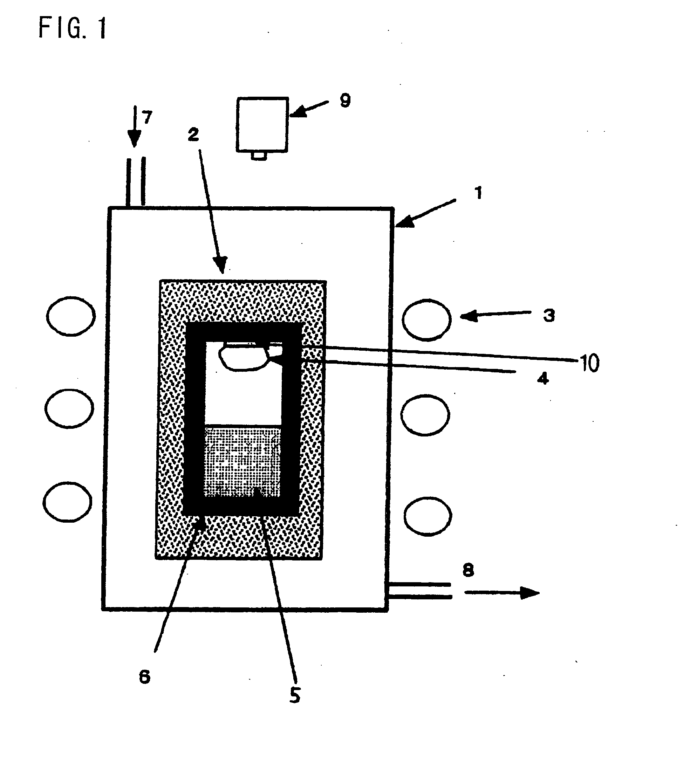

FIG. 1 schematically shows an example of the method for producing an SiC single crystal.

As shown, for example, in FIG. 1, the production method of the present invention is a method in which a crystal growth crucible 6 is covered by a heat insulating material 2 or the like and then arranged inside a reacting furnace 1, the crucible undergoes high-frequency induction heating by a work coil 3, a low temperature region (for example, in proximity to the region indicated by reference numeral 4) and a high temperature region (for example, in proximity to the region indicated by reference numeral 5) are provided inside the crystal growth crucible 6, a seed crystal substrate 10 formed of an SiC single crystal is arranged in the low temperature region of the crystal growth crucible 6, the SiC raw material 5 is arranged in the high temperature region, and a sublimation gas that sublimes from the SiC raw material deposits on the seed crystal substrate 10 to grow the SiC single crystal 4.

During this growth, generally, an inert gas such as argon is fed into the crucible 6 through a feed pipe 7, the inert gas in the crucible 6 is discharged through the gas exhaust port 8, and the pressure inside the reacting furnace is reduced to about 10 Torr (about 1.3 kPa). Note that the heating device may also be a resistance heating type heater. In addition, using these heating means, the temperature of the crystal growth region where the seed crystal is arranged is set to 1800°C to 2300°C, and the coil position and the like are adjusted such that the temperature of the high temperature region where the SiC raw material is arranged becomes 2000°C to 2400°C, which is higher than the temperature of the crystal growth region.

Note that, in the present specification, a description is provided by using an example in which a sublimation gas that directly sublimes from an SiC raw material is used for crystal growth. However, the gist of the present invention lies in the structure of the supporting portion for the SiC seed crystal and the structure of the crystal growth crucible. Naturally, various methods that are directed to the growth of a single crystal, such as using a chemical vapor deposition method (CVD method) in which silane, propane or the like is used as a raw material instead of a sublimation gas, or a liquid phase growth method in which growth is effected by using a Si melt or the like as a solvent can be applied to the growth method in the present invention.

The present invention provides a method for producing an SiC single crystal in which a low temperature region and a high temperature region are provided in a crystal growth crucible, a seed crystal substrate formed of an SiC single crystal is disposed in the low temperature region of the crystal growth crucible, the SiC raw material is disposed in the high temperature region thereof, and a sublimation gas that has been sublimed from the SiC raw material is deposited on the seed crystal substrate to grow the SiC single crystal, in which a material that has a room-temperature linear expansion coefficient that differs from that of SiC by 1.0 × 10⁻⁶/K or less, preferably 0.5 × 10⁻⁶/K or less, and more preferably 0.3 × 10⁻⁶/K or less is used in the crucible member where the low temperature region of the crucible is formed.

In the crystal growth crucible, generally, a material such as graphite, platinum, tantalum or the like is used. However, the difference in thermal expansion rate between these materials and SiC is great, and in the case in which the SiC seed crystal is directly adhered to the crystal growth crucible, the difference in these thermal expansion rates causes a strain on the SiC seed crystal when the temperature increases and decreases during single crystal growth. This strain causes defects in the SiC growth crystal.

In the present invention, the SiC seed crystal is held in a crucible member having room-temperature linear expansion coefficient different from that of SiC by 1.0 × 10⁻⁶/K or less, thereby minimizing the strain that acts on the SiC seed crystal when the temperature is increased or decreased during the single crystal growth. The defects in the growing crystal that are caused by this strain can be thereby reduced. Since the difference in the room-temperature linear expansion coefficient between the member that is used in the present invention and the SiC is most preferably zero, the low temperature region of the crucible of the present invention is preferably fabricated from SiC. In addition, graphite, for which the difference in the linear expansion coefficient is adjusted to 1.0 × 10⁻⁶/K or less, can be suitably used.

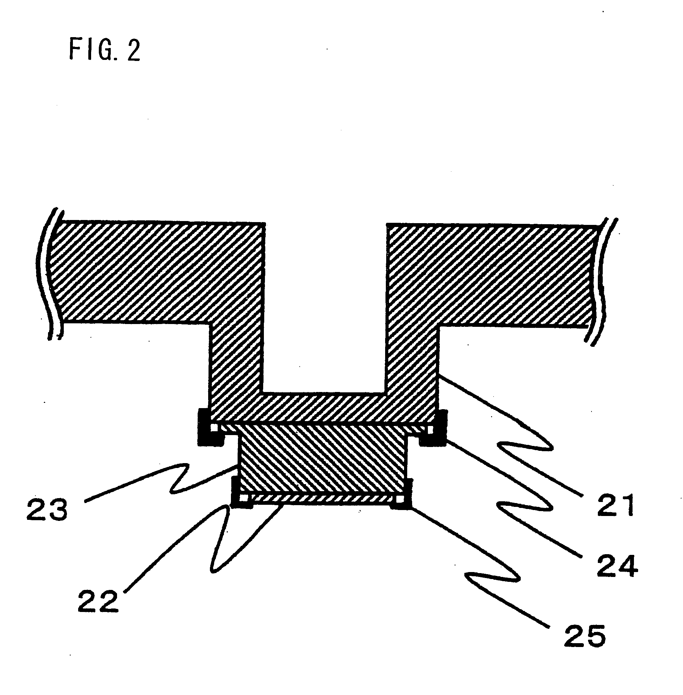

In addition, the present invention is in which, as shown, for example, in FIG. 2, a supporting member 23 formed of a material having a room-temperature linear expansion coefficient that differs from that of SiC by 1.0 × 10⁻⁶/K or less, preferably 0.5 × 10⁻⁶/K or less, and more preferably 0.3 × 10⁻⁶/K or less is arranged between a crystal growth crucible 21 and a seed crystal substrate 22. Due to this arrangement, the strain that acts on the SiC seed crystal when the temperature increases or decreases during single crystal growth can be prevented, and it is possible to prevent this strain from causing defects in the SiC seed crystal.

In the present invention, when the SiC seed crystal is held on the supporting member for the seed crystal or at the low temperature region of the crucible, SiC, which is a material that is identical to the SiC seed crystal, is used to form these locations, and thereby, the strain that acts on the SiC seed crystal when the temperature increases or decreases during single crystal growth is minimized, and defects in the growing crystal that are caused by this strain can be reduced.

In addition, in the method for producing an SiC single crystal of the present invention, preferably, a supporting member that is formed of SiC or a low temperature region of the crucible that is formed of SiC are made from an SiC single crystal. SiC includes polycrystalline SiC that is produced by sintering and the like, and single-crystalline SiC that is produced by sublimation methods and the like. In the supporting member of the present invention, basically either can be used, but the thermal expansion coefficient of polycrystalline SiC differs slightly from that of the single-crystalline SiC that is grown in the present invention. Thus, in the method for producing an SiC single crystal of the present invention, using a single-crystalline SiC in this supporting member can further reduce the strain that acts on the seed crystal more than using the polycrystalline SiC.

In addition, according to experiments carried out by the inventors of the present application, there are cases in which defects are produced during crystal growth at the bonded surface between the polycrystalline SiC supporting member and the SiC seed crystal, and there are cases in which these defects penetrate the seed crystal and propagate to the growth crystal. Thus, by using the structure of the present invention, such a phenomenon can be avoided, and it is possible to produce an SiC single crystal having fewer defects.

In the method for producing an SiC single crystal of the present invention, preferably, the crystal structure of the SiC single crystal supporting member or the low temperature region of the crucible made of an SiC single crystal (hereinafter, referred to simply as the "SiC single crystal supporting portion"), is identical to the crystal structure of the seed crystal, and the crystal face orientations at these locations and the crystal face orientation of the seed crystal are matched. Then the seed crystal is arranged in the crucible. As explained above, in the present invention, the thermal expansion coefficient of the SiC seed crystal and the supporting portion thereof must be minimized, but even for an SiC single crystal, differences of several percent or greater may occur in the thermal expansion rates thereof due to their crystal structure and the crystal orientation. Thus, by making the crystal structure of the SiC single crystal supporting portion and the crystal structure of the seed crystal identical, and matching the crystal face orientation of the SiC single crystal supporting portion and the crystal face orientation of the seed crystal, it is possible to reduce to a minimum the strain that acts on the seed crystal due to the difference in thermal expansion rate. In addition, there are cases in which the above-described defects that are formed at the bonded surface between the SiC supporting portion and the SiC seed crystal are produced due to differences in the crystal structure and the crystal face orientation thereof, and the generation of these defects can also be prevented by the present invention. Note that the expression "matching the crystal face orientations" means that the Si face and the C face of the SiC single crystal are both distinguished, and means that the Si face and the C face are bonded in the case of an identical crystal orientation. Also note that in the present invention, matching the crystal face orientations means that the crystal face orientations are matched within a range from -10° to +10°, more preferably from -5° to +5°, and even more preferably from -1° to +1°.

In addition, in the present invention, preferably, the SiC supporting portion and the SiC seed crystal have a 4H structure and an orientation that has a ±30° offset with respect to the {0001} plane as bonded crystal face orientations. By using this structure and orientation, the strain that acts on the seed crystal is minimized, and in addition, defects that are generated at the bonded interface can be minimized.

In the method for producing an SiC single crystal of the present invention, the thickness of the supporting member that formed of SiC is preferably within a range of 0.7 mm to 10 mm, and more preferably within a range of 5 mm to 10 mm. By maintaining such a range, the effects of preventing the introduction of defects and reducing the density of defects can be obtained.

In the method for producing an SiC single crystal of the present invention, when the seed crystal is arranged in the supporting portion formed of SiC, preferably, the side portion of the seed crystal is held by using a member formed of SiC. In the production method of the present invention, in the case in which the seed crystal is set in a supporting member formed of SiC, bonding by using an adhesive agent having carbon as a main constituent is possible, but, for example, as shown in FIG. 2, by holding the side portion of the seed crystal 22 with using the member 25 formed of SiC, the occurrence of defects at the bonded surface and strain caused by an adhesive agent can be reduced, and crystal growth having less strain becomes possible. In addition, similarly, at the bonded portion between the supporting member 23 and the crucible 21 formed of SiC as well, preferably, bonding is carried out by using a member 24 formed of SiC.

In the method for producing an SiC single crystal of the present invention, as shown in FIG. 2, preferably, the thickness of a wall portion that supports the supporting member in the crystal growth crucible or the low temperature region of the crucible are made thinner than the wall thickness of other locations. In the production method of the present invention, the crystal growth crucible is, for example, heated by high-frequency induction, but the heating temperature of the crucible at this time is influenced by the wall thickness of the crucible. That is, the thickness of the wall portion that holds the supporting member inside the crystal growth crucible or the low temperature region of the crucible are made thinner than the wall thickness of the other locations, and thereby the temperature of these locations is lowered with respect to the overall crucible, the temperature difference between the seed crystal and the low temperature region of the crucible is reduced, and thereby, it becomes possible to reduce the thermal strain that is produced at these locations.

By cutting the crystal that has been produced by the method for producing an SiC single crystal of the present invention in a direction that is parallel to or oblique to the growth direction by using an outer perimeter cutting edge, a wire saw or the like, it is possible to produce an SiC single crystal wafer having few crystal defects. In addition, by using this, it is possible to produce high performance semiconductor devices, and in particular, an inverter element and the like, at a high yield.

### Example

Although an example is shown below, the present invention is not limited thereto.

### (Example)

A seed crystal substrate (50 mm in diameter and 0.4 mm in thickness) composed of a 4H SiC single crystal whose a (000-1) face was exposed was washed with a sulfuric acid-hydrogen peroxide mixed solution at 110°C for 10 minutes, with running ultrapure water for 5 minutes, with an ammonia-hydrogen peroxide mixed solution for 10 minutes, with running ultrapure water for 5 minutes, with a hydrochloric acid-hydrogen peroxide mixed solution for 10 minutes, with running ultrapure water for 5 minutes, and further with an HF solution. Subsequently, after oxidizing the surface at 1200°C, HF washing was carried out again to complete the seed crystal.

In a graphite crucible and having an inner diameter of 70 mm and a depth of 95 mm, SiC raw material powder (made by Showa Denko K.K. and sold under the product code "#240") was packed to a height of 60 mm. Then, the seed crystal was held at a lower surface of a graphite crucible lid by using an SiC single crystal supporting member having the structure that is shown in FIG. 2. The crystal structure of the supporting member was 4H, the orientation was (000-1), and the thickness was 12 mm. A SiC polycrystalline crystal member was used for bonding between the supporting member and the crucible, and an SiC polycrystalline crystal member was used for bonding between the supporting member and the seed crystal. In addition, the wall thickness of the graphite crucible was 10 mm, and the wall thickness of the bonded portion between the crucible and the supporting member was 2 mm.

This lid was disposed on the crucible opening portion, the entire graphite crucible was wrapped in a heat insulating material made of carbon fibers and set in a reaction chamber in a high-frequency heating furnace. The pressure in the interior of the reaction tube was reduced to 5 × 10⁻⁵ Torr via a gas exhaust port 8, then the reaction tube was filled to normal pressure with argon gas that was fed through an inert gas inlet 7, and subsequently the pressure was again reduced to 5 × 10⁻⁵ Torr through the gas exhaust port to expel the air from inside the reaction tube. Then, the reaction tube was filled again with the argon gas introduced through the inert gas inlet to 700 Torr, the upper portion of the graphite crucible was heated to 2200°C, and the lower portion thereof was heated to 2250°C to 2300°C. Thereafter, the gas was evacuated via the gas exhaust port, the pressure of argon atmosphere was reduced to 5.3 kPa, and growth was carried out for 20 hours.

The obtained crystal was cut perpendicularly to the growth direction, subject to mirror polishing, and a semiconductor wafer having a diameter of 50 mm was thereby produced. The characteristics of this semiconductor wafer were superior in being micropipe-free and having a dislocation density that was lower than the conventional semiconductor wafers.

### Industrial Applicability

Since SiC has superior thermal conductivity, heat resistance and mechanical strength, this single crystal can be used in various applications, such as a semiconductor device and an inverter that is composed thereof. In particular, one focus is the usage of SiC as a power device for power control.

## Claims

1. A method for producing an SiC single crystal, comprising: providing a low temperature region and a high temperature region in a crystal growth crucible; disposing a seed crystal substrate formed of an SiC single crystal in the low temperature region of the crystal growth crucible; disposing an SiC raw material in the high temperature region; and depositing a sublimation gas that sublimes from the SiC raw material on the seed crystal substrate to grow the SiC single crystal,
wherein a material used in the crucible member where the seed crystal is disposed is a material having a room-temperature linear expansion coefficient that differs from that of SiC by 1.0 × 10⁻⁶/K or less.

2. A method for producing an SiC single crystal according to claim 1, wherein the crucible member where the seed crystal is disposed is made of SiC.

3. A method for producing an SiC single crystal according to claim 1, wherein the crucible member where the seed crystal is disposed is made of an SiC single crystal.

4. A method for producing an SiC single crystal according to claim 3, wherein the crystal structure of the crucible member where the seed crystal is disposed and the crystal structure of the seed crystal are identical.

5. A method for producing an SiC single crystal according to claim 3 or 4, wherein the crystal face orientation of the crucible member where the seed crystal is disposed and the crystal face orientation of the seed crystal are matched so as to be within a range of -10° to +10°.

6. A method for producing an SiC single crystal according to any one of claims 3 to 5, wherein the crystal structure of the crucible member where the seed crystal is disposed is 4H.

7. A method for producing an SiC single crystal according to claim 5 or 6, wherein the crystal face orientation is an orientation having an offset within a range of +30° to -30° with respect to {0001}.

8. A method for producing an SiC single crystal according to any one of claims 1 to 7, wherein the thickness of the crucible member where the seed crystal is disposed is within a range of 0.7 mm to 50 mm.

9. A method for producing an SiC single crystal according to any one of claims 1 to 9, wherein, when the seed crystal is disposed in the crucible member where the low temperature region is formed, a side portion of the seed crystal is held by using a member made of SiC.

10. A method for producing an SiC single crystal according to any one of claims 1 to 9, wherein the thickness of the wall portion inside the crystal growth crucible where the seed crystal is disposed is thinner than the wall thickness at other locations.

11. A method for producing an SiC single crystal, comprising: providing a low temperature region and a high temperature region in a crystal growth crucible; disposing a seed crystal substrate formed of an SiC single crystal in the low temperature region of the crystal growth crucible; disposing an SiC raw material in the high temperature region; and depositing a sublimation gas that sublimes from the SiC raw material on the seed crystal substrate to grow an SiC single crystal,
wherein a material having a room-temperature linear expansion coefficient that differs from that of SiC by 1.0 × 10⁻⁶/K or less is used as an SiC seed crystal supporting member between the crucible member where the low temperature region is formed and the seed crystal substrate.

12. A method for producing an SiC single crystal according to claim 11, wherein the SiC seed crystal supporting member is made of SiC.

13. A method for producing an SiC single crystal according to claim 11, wherein the SiC seed crystal supporting member is made of an SiC single crystal.

14. A method for producing an SiC single crystal according to any one of claims 11 to 13, wherein the crystal structure of the SiC seed crystal supporting member is identical to the crystal structure of the seed crystal.

15. A method for producing an SiC single crystal according to any one of claims 11 to 14, wherein the crystal face orientation of the SiC seed crystal supporting member and the crystal face orientation of the seed crystal are matched so as to be within a range of -10° to +10°.

16. A method for producing an SiC single crystal according to any one of claims 13 to 15, wherein the crystal structure of the SiC seed crystal supporting member is 4H.

17. A method for producing an SiC single crystal according to claim 15 or 16, wherein the crystal face orientation is an orientation having an offset within a range of +30° to - 30° with respect to {0001}.

18. A method for producing an SiC single crystal according to any one of claims 11 to 17, wherein the thickness of the SiC seed crystal supporting member is within a range of 0.7 mm to 50 mm.

19. A method for producing an SiC single crystal according to any one of claims 11 to 18, wherein, when a seed crystal is disposed on the SiC seed crystal supporting member, a side portion of the seed crystal is held by using a member made of SiC.

20. A method for producing an SiC single crystal according to any one of claims 11 to 19, wherein the thickness of the wall portion that holds the supporting member in the crystal growth crucible is thinner than the wall thickness at other locations.

21. A semiconductor device using the single crystal produced by using the method for producing an SiC single crystal according to any one of claims 1 to 20.

22. An inverter that is composed of the semiconductor device according to claim 21.
